Europäisches Patentamt

European Patent Office

Office européen des brevets

(19)

(11) Publication number: **0 0 1 7 0 2 2**
**A1**

# EUROPEAN PATENT APPLICATION

(12)

(21) Application number: **80101240.2**

(22) Date of filing: **11.03.80**

(51) Int. Cl.³: **H 01 L 29/90,** H 01 L 27/06, H 01 L 27/08

(30) Priority: **09.04.79 US 28281**

(43) Date of publication of application: **15.10.80 Bulletin 80/21**

(84) Designated Contracting States: **DE FR GB IT**

(71) Applicant: **International Business Machines Corporation, Armonk, N.Y. 10504 (US)**

(72) Inventor: **Atwood, Bruce Coleman, RR2, Box 291 Juniper Ridge, Shelburne Vermont (US)**
Inventor: **Muggli, Raymond Allen, 7030 Via del Rio, San Jose California 95139 (US)**

(74) Representative: **Chaudhry, Mohammad Saeed, IBM United Kingdom Patent Operations Hursley Park, Winchester Hants, S021 2JN (GB)**

(54) **A zener diode and method of fabrication thereof.**

(57) This invention relates to a subsurface breakdown zener diode having an internally protected P-N junction and a method of fabrication thereof. A semiconductor substrate (10) of one conductivity type (P) has a deposit of semiconductor material (P⁺) of the same conductivity type but more heavily doped over which an epitaxial layer (14') of semiconductor material of another semiconductor conductivity type (N) is grown and whereby the deposit becomes a buried layer (12'). Semiconductor material of the one conductivity type and intermediate doping is diffused into an annular region (18) in the epitaxial layer while at the same time a quantity of the same material is diffused into a region (20') centrally of and spaced from the annular region (18'). Both diffusions are carried out to contact with the buried layer (12'). Material (28') of the other conductivity type and doped more heavily than the epitaxial layer (14') is diffused over the centrally diffused material and carried out to convert the first diffusion to the opposite conductivity type for a substantial depth into the epitaxial layer (14') whereby a pn⁺ junction is formed completely beneath the surface. Contacts for the zener diode are made to the annular diffusion region (18') and the diffusion region (28').

ACTORUM AG

1

A ZENER DIODE AND METHOD OF FABRICATION THEREOF

The invention relates to a zener diode assembly and a method
of fabrication thereof.

The term zener diode has long been applied to two electrode
semiconductor devices operating with respect to the phenomena of
the breakdown in solid dielectrics below approximately 5 volts,
and of the avalanche effect corresponding to the townsend discharge
effect in dielectrics at potentials above approximately 5 volts.
Zener diode devices are widely used as potential or "voltage"
regulating devices, particularly in reference potential generating
circuitry. Conventional IC devices very frequently include a
number of zener diode devices, a number of transistor devices, and
auxiliary circuit components and connections on a single semiconductor wafer or chip.

As the electronics arts have progressed, better and better
zener diode devices and circuit arrangements have been developed.
Examples of such improved zener diode circuits are found in the
technical literature. There have been problems however with the
prior art devices, for example, especially with respect to variations of the breakdown voltage, as a function of time and/or
changes in temperature. It has been suggested that the causes of
instability are related to the presence of the passivating insulating
layer of silicon dioxide which lies adjacent to the silicon facing
surface where avalanche breakdown takes place in the conventional
zener diode devices. The prior art contains literature and patents
that have proposed fabricating zener diode devices with subsurface
avalanche breakdown regions, and to the extent that they are able, these prior art arrangements have proven successful. However, among the drawbacks of the present state of the art subsurface zener diodes are that an $n^+$ diffusion into a p base results in a p pinch resistance that tends to a high dynamic impedance. Another drawback resides in considerable deformation damage due to diffusing a high emitter $n^+$ concentration into a high $p^+$ concentration resulting in problems in reliability and consequent reduction in yield.

U.S. Patent 3,881,179 discloses a zener diode structure wherein the breakdown is subsurface due to enhanced p diffusion under an $n^+$ diffusion, but wherein there still is a pn junction at the surface over which there is an $\varepsilon$ field tending to ionize contaminants on that surface.

U.S. patent 4,079,402 discloses a zener diode structure, wherein an ion implanted layer is arranged to establish the avalanche breakdown below the surface, and wherein there also is a portion of the p-n junction at the facing surface. A pinch resistance component also exists resulting in a high dynamic impedance.

A lower dynamic impedance is provided by a zener diode structure disclosed in U.S. Patent No. 4,136,349. This structure in fact has a part of the avalanche breakdown junction at the surface but this is nullified in effect by a shallow doping extending laterally of the junction to overcome the problem at least in part.

None of these patents shows or suggests a structure according to the invention wherein the entire avalanche breakdown pn junction is completely below the surface and the dynamic impedance is sufficiently low that buffering is entirely unnecessary.

According to the invention there is provided a zener diode assembly, characterised in that the assembly comprises, a semiconductor substrate of a first semiconductor conductivity type material, a layer of semiconductor material of a second semiconductor conductivity type arranged over said substrate and extending from said substrate to a facing surface, a layer of said first semiconductor conductivity type buried in said substrate and in the first said layer and beneath said facing surface, a first portion of semiconductor material of said second semiconductor conductivity type arranged in said layer of semiconductor material and extending from said facing surface toward said buried layer and spaced therefrom, a second portion of semiconductor material of said first semiconductor conductivity type arranged in said layer and spaced from said first portion and extending from said facing surface to said buried layer, and a third portion of semiconductor material of said first semiconductor conductivity type arranged in said layer and spaced from said second portion and contained between the surface of said first portion remote from said facing surface and said buried layer, said buried layer having a dopant concentration higher than that of said substrate and said third portion having a dopant concentration intermediate those of said substrate and said buried layer.

Further according to the invention there is provided a method for producing a zener diode assembly characterised in that the method comprises the steps of selecting a substrate of a first semiconductor conductivity type material, depositing on said substrate semiconductor material of said first conductivity type having a dopant concentration higher than that of said substrate, growing a layer of semiconductor material of a second semiconductor conductivity type over said substrate and said deposited material whereby, due to subsequent steps, said deposited material diffuses into said substrate and into said grown layer and becomes a buried layer beneath a facing surface of said grown layer, diffusing a quantity of semiconductor material of said first conductivity type into said grown layer centrally of said buried layer and another quantity of said material in a region surrounding and spaced apart from said centrally arranged quantity with both of said quantities being diffused into contact with said buried layer, and said quantities having a dopant concentration intermediate that of said substrate and said buried layer, diffusing another quantity of semiconductor material of said second conductivity type and higher concentration than that of said grown layer into said centrally located diffusion of said first conductivity type and into a region of said grown layer and spaced from said diffusion of said other quantity for subsequently producing an integral region of said second semiconductor conductivity type at said facing surface and a semiconductor junction of said first and said second semiconductor conductivity types within said grown layer.

A zener diode assembly embodying the invention has a pn avalanche breakdown junction formed completely beneath the facing surface of the overall semiconductor chip or wafer. A semiconductor substrate of one semiconductor conductivity type is arranged with a deposit of semiconductor material of the same conductivity type but more heavily doped, over which an epitaxial layer of semiconductor material of another semiconductor conductivity type is grown, and whereby the deposit subsequently diffuses into the substrate and into the epitaxial layer and becomes a buried layer. Semiconductor material of the one conductivity type and of intermediate doping

5

concentration is diffused into an annular region in the facing surface of the epitaxial layer, while at the same time a quantity of the same material and same doping is diffused into a region centrally of and separated from the annular region. Both diffusions are processed to make contact with the buried layer. Next, material of the other semiconductor conductivity type and doped more heavily than the material in the epitaxial layer, and also doped more heavily than the material in the central region, is diffused over the centrally diffused material. This diffusion is carried out to convert a portion of the first diffusion nearest the surface to the opposite conductivity type for substantial depth into the epitaxial layer. This forms an avalanche breakdown pn junction completely beneath the facing surface of the semiconductor wafer or chip. The operating output regions of the zener diode thus formed to which electric contact is to be made, comprise the annular diffusion region and the converting diffusion region to which regions metallic electrodes are attached.

The zener diode embodying the invention is smaller than that of the prior art devices because of the absence of any pinch resistance element. Also because the annular diffusion region also serves as an isolating medium between the zener diode thus described and the remainder of the circuitry on the same wafer or chip, even less area is required in the given semiconductor circuit wafer or chip than would be required with prior art arrangements.

The advantages of the zener diode structure embodying the invention reside in the reduction of flicker noise and the slower reduction of stability with age, both due to the reduction in mobile surface charges. Also the zener diode structure embodying the invention has a dynamic impedance characteristic sufficiently low that there is no need of any buffer circuit.

The concept of enhancement is not used but rather the concept embodying the invention is containment. The key to the concept is that of containing the p base beneath the small $n^+$ diffusion and making the anode connection by way of the $p^+$ buried isolation layer. The avalanche breakdown junction is the entire subsurface contiguous area of the $n^+p$ junction whereby the current density is readily maintained at a better than safe value.

The invention will now be described by way of example with reference to the accompanying drawings in which :-

FIG. 1 and FIG. 2 are plan and cross-section views respectively of a zener diode assembly embodying the invention;

FIG. 3 and FIG. 4 are cross-section views showing the course of fabrication of zener diode assembly embodying the invention;

FIG. 5 is a graphical representation of the doping concentration profile below the facing surface of the assembly embodying the invention; and

FIG. 6 is a cross-section view of another embodiment of a zener diode assembly according to the invention together with a transistor laid down in the same fabrication process.

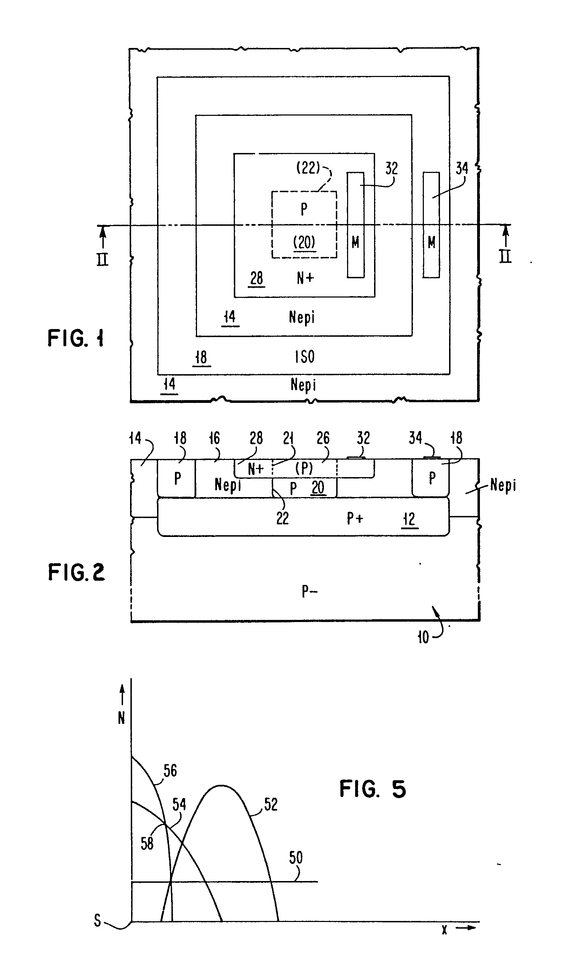

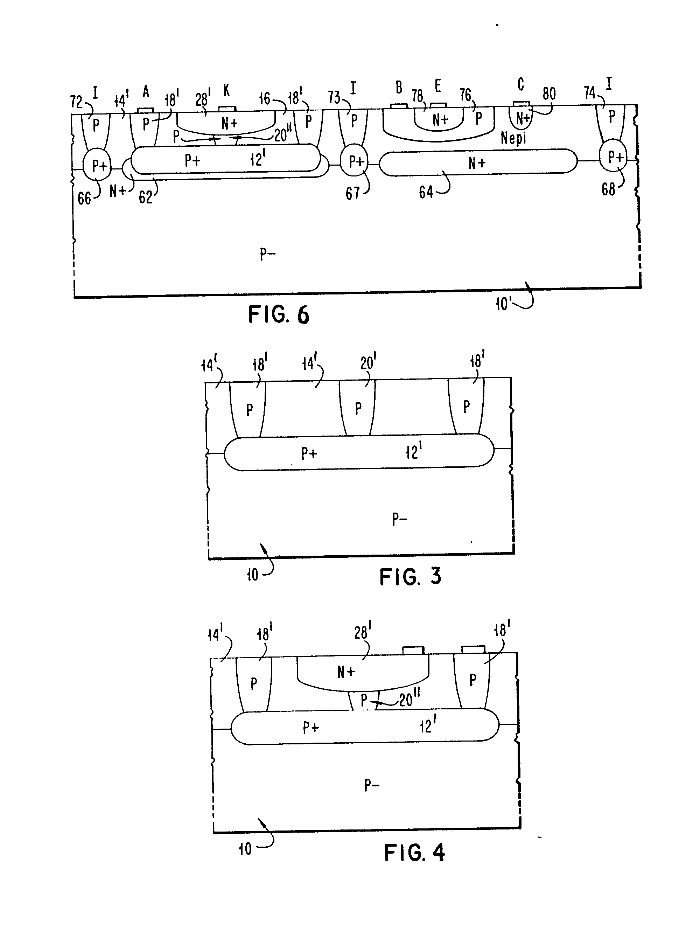

An embodiment of a zener diode as fabricated according to the invention is shown in FIGS. 1 and 2. FIG. 1 is a plan view and is much in the way of superimposed mask outlines as used in a conventional monolithic fabrication process. FIG. 2 is a cross-section taken at the line II-II and again in the interest of clarity, is much in the way of vertical projection of the mask outlines. Those skilled in the art will recognize the advantages of this particular depiction and immediately will correlate with the configuration as actually realized, as for example, a configuration similar to that shown in FIG. 4 which is generally realized. The zener diode embodying the invention and other electronic semiconductor components and circuitry used therewith is assembled on a substrate 10. As shown in FIGS. 1 and 2, the substrate 10 is a wafer of substantially pure silicon doped with a positive dopant of given concentration and denoted here as $p^-$. In conventional manner, a quantity of semiconductor material of higher concentration, denoted here as $p^+$, is deposited on the substrate 10 for subsequently forming a conventional subsurface layer 12. Over the substrate 10 and this deposited material an epitaxial layer 14 of semiconductor material of opposite conductivity type, denoted here as $n^{epi}$, is grown in conventional manner. As heat is applied in the subsequent processing steps, the deposit of $p^+$ material will diffuse down into the substrate 10 and up into the epitaxial layer 14 resulting in the formation of the buried isolation layer 12 as shown.

The next step in this sequence of steps for the zener diode structure is a simultaneous diffusing of semiconductor material of the first semiconductor conductivity type, shown here as p type, having a concentration intermediate that of the substrate 10 and

8

that of the buried layer 12, in an annular or rectangular ring 18 and in a region centrally of the ring as shown here. Both of these diffusion regions begin at the surface 16 and they are both carried out until each makes good conductive contact with the buried layer 12. At this instant in time, the centrally located diffusion of p material has a boundary, which in the ideal sense as previously mentioned, comprises four surfaces indicated by the broken line 21 and the line 22. This is shown more clearly by the cross-section diagrams of FIGS. 3 and 4 wherein the diffusion regions appear more like those normally encountered. The upper region 26 of the region resulting from the centrally located diffusion is converted from the diffused p material to a diffused $n^+$ region of semiconductor material of the opposite conductivity type and heavier concentration than that of of the epitaxial layer 14 and that of the p type material. Thus the region 26 merges into a larger region 28 of $n^+$ material. The zener diode pn junction is located at the contiguous area between the p region 20 and the $n^+$ region 28. This area is large whereby the current density is relatively low. The entire $pn^+$ junction is well beneath the surface 16. A metal terminal 32 is attached to cathode region 28 and a metal terminal 34 is attached to the region 18 by a conventional method known to a person skilled in the art of fabrication of semiconductor devices.

While those skilled in the art will fabricate zener diode structures according to the invention in terms of dimension with which they are familiar, some typical dimensions are listed in Table I below.

## TABLE I

| | |
|---|---|
| Substrate 10 (depth-1.15mm) | 1150 microns |
| Epitaxial layer 14 (depth) | 4 microns |
| Cathode region 28 (depth) | 1 micron |
| Anode region 20 (depth below surface) | 1.5 microns |
| Anode region 20 (thickness) | 0.5 microns |
| Buried layer 12 (depth below surface) | 1.5 microns |
| Annulus 18 (width at surface) | 10 microns |
| Annulus 18 (inside at surface) | 36 x 36 microns |
| Cathode region 28 (at surface) | 26 x 26 microns |
| Anode region 28 (at zener junction) | 20 x 20 microns |

Zener diodes according to the description above have been made with the concentrations given in Table II below.

## TABLE II

| | |
|---|---|
| Substrate 10 Boron doped Silicon | $10^{15}/cm^3$ $p^-$ |
| Anode regions 18,20 Boron dopant | $10^{17}/cm^3$ $p$ |
| Buried layer 12 Boron dopant | $10^{19}/cm^3$ $p^+$ |
| Epitaxial layer 14 Arsenic dopant | $10^{16}/cm^3$ $n^{epi}$ |
| Cathode region Arsenic dopant | $10^{20}/cm^3$ $n^+$ |
| Isolating layer 62 Arsenic dopant | $10^{19}/cm^3$ $n$ |

It should be understood that these skilled in the art will fabricate the zener diode embodying the invention with the opposite conductivity by interchanging p material for n material and the converse by ion implantation rather than diffusion without otherwise departing from the teaching herein.

FIG. 5 is a graphical representation of the doping concentration as related to depth below the facing surface of the IC device according to the invention. The curve 50 represents the epitaxial concentration reference level. The curve 52 represents a conventional buried isolation layer diffusion profile. The curve 54 represents a conventional base diffusion profile, while the curve 56 represents a conventional emitter diffusion profile. The avalanche breakdown occurs at the concentration represented by the crossover point 58. The curves are essentially the same for the ion implantation process as for the diffusion process as shown.

The zener diode disclosed thus far must be referenced to the most negative operating potential on the chip or wafer because the buried layer 12 is in electric contact with the substrate 10. This is a disadvantage only if a reference potential is desired with regard to ground and there is a potential on the chip or wafer that is negative with respect to ground. For this application an alternate embodiment of the invention is arranged as shown in FIG. 6.

The alternate structure is shown with a n-p-n transistor as fabricated simultaneously. In the interest of clarity the polarities are shown as for the previous embodiment, but it is to be understood that the teaching applies to other similar structures. A substrate of $p^-$ material is first processed to form $n^+$ regions 62 and 64. Then $p^+$ regions 12', 66, 67 and 68 are formed after which the epitaxial layer 14' is grown. Simultaneously p regions 18', 20" (from the surface 16'), 72, 73, 74 and 76 are formed. Then $n^+$ regions 28', 78 and 80 complete the devices except for electric contacts and like elements.

11

CLAIMS

1. A zener diode assembly, characterised in that the assembly comprises, a semiconductor substrate (10) of a first semiconductor conductivity type material (P), a layer (14') of semiconductor material of a second semiconductor conductivity type (N) arranged over said substrate (10) and extending from said substrate to a facing surface, a layer (12') of said first semiconductor conductivity type buried in said substrate (10) and in the first said layer (14') and beneath said facing surface, a first portion (28') of semiconductor material of said second semiconductor conductivity type arranged in said layer (14') of semiconductor material and extending from said facing surface toward said buried layer (12') and spaced therefrom, a second portion (18') of semiconductor material of said first semiconductor conductivity type arranged in said layer (14') and spaced from said first portion (28') and extending from said facing surface to said buried layer (12'), and a third portion (20') of semiconductor material of said first semiconductor conductivity type arranged in said layer (14') and spaced from said second portion (18') and contained between the surface of said first portion (28') remote from said facing surface and said buried layer (12'), said buried layer (12') having a dopant concentration higher than that of said substrate (10) and said third portion (20') having a dopant concentration intermediate those of said substrate (10) and said buried layer (12').

2. A zener diode assembly as claimed in claim 1, including a first element of conductive material electrically contacting said first portion, and a second element of conductive material electrically contacting said second portion.

12

3. A zener diode assembly as claimed in claim 1 or 2, including a fourth portion of semiconductor material of said second semiconductor conductivity type interposed between said substrate and said buried layer.

4. A zener diode assembly as claimed in claim 3, where said fourth portion has a dopant concentration substantially equal to that of said first portion.

5. A zener diode assembly as claimed in any one of the preceding claims, wherein said second portion is arranged entirely around said first portion.

6. A zener diode assembly as claimed in any one of the preceding claims, wherein said first portion has a dopant concentration greater than that of said layer of said second conductivity type arranged over said substrate.

7. A method for producing a zener diode assembly characterised in that the method comprises the steps of selecting a substrate (10) of a first semiconductor conductivity type material (P), depositing on said substrate (10) semiconductor material of said first conductivity type having a dopant concentration higher than that of said substrate (10), growing a layer (14') of semiconductor material of a second semiconductor conductivity type (N) over said substrate (10) and said deposited material whereby, due to subsequent steps, said deposited material diffuses into said substrate and into said grown layer (14') and becomes a buried layer (12') beneath a facing surface of said grown layer (14'), diffusing a quantity of semiconductor material (20') of said first conductivity type into said grown layer (14') centrally of said buried layer (12') and another quantity of said material (18') in a region surrounding and spaced apart from said centrally arranged quantity with both of said quantities being diffused into contact with said buried layer (12'), and said quantities having a dopant concentration intermediate that of said substrate (10) and said buried layer (12'), diffusing another quantity (28') of semiconductor material of said second conductivity type and higher concentration than that of said grown layer (14') into said centrally located diffusion of said first conductivity type and into a region of said grown layer (14') and spaced from said diffusion of said other quantity (18') for subsequently producing an integral region of said second semiconductor conductivity type at said facing surface and a semiconductor junction of said first and said second semiconductor conductivity types within said grown layer (14').

8. A method as claimed in claim 7, including forming electric contacts on a portion of said centrally located diffusion of semiconductor material of said second conductivity type and on a portion of said diffusion of said other quantity of material of said first conductivity type.

9. A method as claimed in claim 7 or 8, including diffusing material of said second conductivity type into said substrate over which said material of said first conductivity type is deposited.

10. A method as claimed in any one of claims 7, 8 and 9, wherein said diffusing steps are replaced by ion implantation steps.

FIG. 1

FIG. 2

FIG. 5

FIG. 6

FIG. 3

FIG. 4

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| | 1972 IEEE INTERNATIONAL SOLID-STATE CIRCUITS CONFERENCE,Digest of technical papers; New York 1972 US I.D. LIEUX et al.: "An ultra-stable voltage reference using a new type of bulk Zener diode", pages 148-149. <br><br> * Entire document * | 1 | H 01 L 29/90     27/06     27/08 |
| | | | **TECHNICAL FIELDS SEARCHED (Int.Cl. 3)** <br><br> H 01 L 29/90     27/06     27/08 |

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 09-05-1980 | PELSERS |

EPO Form 1503.1 06.78